Europäisches Patentamt

European Patent Office

Office européen des brevets

(11) Publication number: **0 366 886**
**A1**

## EUROPEAN PATENT APPLICATION

(21) Application number: **89114894.2**

(22) Date of filing: **11.08.89**

(51) Int. Cl.⁵: **H01L 21/471 , H01L 31/18 , H01L 31/113 , H01L 27/146**

(30) Priority: **30.09.88 US 251726**

(43) Date of publication of application:
**09.05.90 Bulletin 90/19**

(84) Designated Contracting States:
**DE FR GB**

(71) Applicant: **TEXAS INSTRUMENTS INCORPORATED**
**13500 North Central Expressway**
**Dallas Texas 75265(US)**

(72) Inventor: **Strong, Roger Lynn**
**2512 Royal Oaks Drive**
**Plano, Texas 75265(US)**

(74) Representative: **Leiser, Gottfried, Dipl.-Ing. et al**
**Patentanwälte Prinz, Leiser, Bunke & Partner**
**Manzingerweg 7**
**D-8000 München 60(DE)**

(54) Passivated compound semiconductor structure.

(57) A passivated semiconductor device and a process for forming such a device. In one form the device comprises a first layer having an upper surface formed of II - VI compound semiconductor material and an insulative layer formed in direct contact with the upper surface of the semiconductor layer. The device is characterized by the absence of an intermediate native oxide layer within 30 Angstroms of the resulting interface, an interfacial roughness of at least 5 Angstroms and a diffusion region of thickness Z wherein Z ranges from zero to 10 Angstroms.

According to the process for forming the device a passivation layer is deposited in direct contact with the surface of a sample of compound semiconductor material. The resulting structure is characterized by the absence of an intermediate layer of native oxide. In one embodiment of the process the surface of the compound semiconductor sample is treated to remove surface contaminants such as oxides of the semiconductor material before depositing the passivation layer.

ZnS/HgCdTe INTERFACE AS DEPOSITED

Fig.1

# PASSIVATED COMPOUND SEMICONDUCTOR STRUCTURE

## FIELD OF THE INVENTION

This invention relates to semiconductor devices and more particularly to a passivated compound semiconductor structure and a method for making such.

## BACKGROUND

Electrical characteristics of semiconductor devices are known to be significantly affected by the chemical nature of the semiconductor surface about which the devices are fabricated. More specifically, various densities of charges and traps may be associated with the transition region at the interface of the semiconducting material and the adjoining insulative layer of an MIS device.

In the fabrication of devices on silicon excellent surface passivation can be obtained in a rather straight forward manner by the growth of thermal oxides or nitrides of the substrate material at temperatures in the range of $1000°$ C. Due to thermal limitations such insulative layers cannot be so readily grown on many compound semiconductor materials. Most, if not all, efforts to otherwise form insulative layers on compound semiconductor materials, e.g., by low temperature deposition processes, typically have not provided the quality of passivation necessary to achieve acceptable electrical characteristics or acceptable levels of stability. In part these shortcomings result from the relatively severe environmental conditions in which compound semiconductor devices are designed to operate. For example, it is desirable that the electrical characteristics of infrared imaging devices remain stable under extreme radiation and temperature conditions.

Alloys of mercury telluride and cadmium telluride, generically denoted $Hg_{1-x}Cd_xTe$ are extensively employed as photosensitive semiconductors for infrared radiation detection. This is because $Hg_{.8}Cd_{.2}Te$ has a band gap of about 0.1 eV, which corresponds to a photon wavelength of 12 micrometers, and $Hg_{.73}Cd_{.27}Te$ has a bandgap of 0.24 eV, which corresponds to a photon wavelength of 5 micrometers. These two wavelengths are in the atmospheric windows of greatest interest for infrared detectors. Both p-n junction photo diode arrays and MIS photocapacitor arrays of $Hg_{1-x}Cd_xTe$ provide satisfactory focal plane imaging in the infrared regime.

Thermal growth of oxides on $Hg_{1-x}Cd_xTe$ is not feasible due to the outdiffusion of mercury at temperatures above $200°$ C. Consequently, efforts have been made to passivate $Hg_{1-x}Cd_xTe$ by deposition of silicon dioxide or zinc sulfide. See, for example, U.S. Patent No. 4,447,469 which discloses a low-temperature process for depositing a layer of sulfide on a substrate. Generally, the surface state density and the accumulated surface charge density of the resulting $Hg_{1-x}Cd_xTe$ structures exhibit unacceptable variations across a sample or device. For example, Kajihari et al. report that deposited zinc sulfide gives inconsistent interfaces on surfaces due to contamination during the fabrication process. See J. Electrochemical Soc.: SOLID-STATE SCIENCE AND TECHNOLOGY, p. 1252, May 1988.

In contrast, electrochemical growth of a passivating oxide layer into the surface of the $Hg_{1-x}Cd_xTe$ structure has provided some improvements in device performance. Anodized surfaces have been formed with oxides of mercury, cadmium and tellurium through a reaction with KOH. See U.S. Patent No. 3,977,018. However, this anodic oxide layer remains temperature sensitive, i.e., detectors degrade at about $80°$ C, and the devices also exhibit instability at room temperature after extended periods of storage. Therefore, formation of surface layers comprising other chalcogenides such as sulfides and/or selenides has been preferred, e.g., by conversion of the oxide layer as disclosed in U.S. Patent Application No. 824,897, or by anodic sulfidization as disclosed by Teherani et. al, in U.S. Patent No. 4,632,886. Teherani et. al disclose electrochemical growth of sulfides in an ethylene glycol solution containing $Na_2S$. Anodically grown sulfide passivation layers are stable up to $100°$ C thus providing an improvement over the anodic oxide process and the various methods used to deposit passivation films.

Disadvantages of the anodic growth process (e.g., complex instrumentation; the requirement for bussing current through the $Hg_{1-x}Cd_xTe$ substrate; physical damage to the substrate caused by the electrical contact; and resistive losses through the substrate which can result in a nonuniform passivation layer) have led to an electroless technique of forming chalcogenide passivation layers such as sulfides and selenides. See copending U.S. Application No. 101,056 (filed 9/25/87, assigned to the assignee of the present invention and now incorporated herein by reference), which discloses a method for growing a passivation layer on a semiconductor substrate in a solution containing polysulfide and/or polyselenide ions.

Direct electroless chemical growth with polysulfides and polyselenides overcomes several of the disadvantages of the electrochemical processes while providing a relatively stable passivated structure. On the other hand, device fabrication has in many applications required that a relatively thick insulative layer having optimal dielectric properties be deposited over the passivation layer. With respect to $Hg_{1-x}Cd_xTe$ this is because the sulfide or selenide layer formed of the semiconductor material typically has a lower dielectric constant than certain deposited insulators such as ZnS. Thus passivated structures formed by electroless growth, as well as the other aforementioned growth techniques, have required separate and distinct formation of the passivation layer as an intermediate to the insulator and the semiconductor material.

U.S. Patent No. 4,447,469 also suggests a low temperature photochemical process for growing native sulfide on a semiconductor substrate. However, the sulfide layer is limited to thicknesses on the order of 100 Angstroms because thicker films require growth temperatures exceeding 150° C. Such elevated temperatures result in dopant outdiffusion and/or increase both the surface state density and the generation-recombination center density. In order to protect the very thin native sulfide layer and provide dielectric material for a semiconductor device, an insulating layer is deposited over the native sulfide. Furthermore, certain disclosed precursors of the photochemical reaction, such as the carbonyl sulfide (COS), may produce oxide contaminants as well as carbon containing compounds. It is well known that these byproducts have adverse effects on the electrical characteristics of the final structure.

## SUMMARY OF THE INVENTION

Accordingly, there are provided a passivated semiconductor device and a process for forming such a device. The device comprises a layer having an upper surface formed of II - VI compound semiconductor material and an insulative layer formed in direct contact with the upper surface of the semiconductor layer. The device is characterized by the absence of an intermediate native oxide layer within 30 Angstroms of the resulting interface, an interfacial roughness of at least 5 Angstroms and a diffusion region of thickness Z wherein Z ranges from zero to 10 Angstroms.

According to an alternate form of the invention the device includes a passivation layer formed in direct contact with the upper surface of a semiconductor layer. The resulting interface is characterized by an interfacial roughness of at least 5 Angstroms and a compositionally graded diffusion region of thickness Z wherein Z ranges from zero to 10 Angstroms. The device is further characterized in that within the layer of II - VI semiconductor material less than 20 percent of any chalcogenide within 30 Angstroms of the interface is in an oxidized state.

According to the process for forming the device a passivation layer is deposited in direct contact with the surface of a sample of compound semiconductor material. The resulting structure is characterized by the absence of an intermediate layer of native oxide. In one embodiment of the process the surface of the compound semiconductor sample is treated to remove surface contaminants such as oxides of the semiconductor material before depositing the passivation layer.

## BRIEF DESCRIPTION OF THE DRAWINGS

The invention may best be understood by reference to the following detailed description of illustrative embodiments when read in conjunction with the accompanying drawing, wherein:

Figure 1 is a lattice image illustrating in partial cross sectional view the structure of a preferred embodiment semiconductor device according to the invention;

Figure 2 schematically presents an exemplary photocapacitive detector array in a cut-away partial cross sectional view to illustrate a detector element constructed according to the present invention;

Figure 3 schematically illustrates in a partial cross sectional view a photodiode detector array 50 comprising a passivation layer formed along the semiconductor surface over individual array elements; and

Figure 4 is an electron micrograph illustrating a characteristic interface region formed by a passivation layer and a semiconductor surface passivated according to the invention.

Certain preferred embodiments of the invention are disclosed herein. However, it should be appreciated that the present invention is applicable to a wide variety of semiconductor structures which can be formed with a variety of materials depending upon the particular application. The specific semiconductor materials which are disclosed are merely illustrative of the many ways to embody the invention and do not limit the scope of the invention.

## DETAILED DESCRIPTION OF THE INVENTION

Passivation is the process of treating semiconductor surfaces in order to enhance uniformity and stability of electrical properties on an integrated circuit structure. As accomplished with the above noted growth of thermal oxides on silicon, the passivation process may involve reaction of the semiconductor constituents positioned about the surface to "tie up" loose or dangling bonds which would otherwise remain chemically unstable. Thus as understood herein a "passivated semiconductor structure" comprises one or more surfaces which have been treated to provide acceptable electrical performance characteristics for a particular application such as, for example, data storage or imaging. Passivation processes as now discussed are to be distinguished from those processes which merely provide physical passivation such as by deposition of a thick protective layer which isolates an underlying layer of material from physical damage. According to the present invention the passivation process further comprehends avoidance and removal of residual surface contaminants resulting from various processing steps, which contaminants may adversely affect the electrical operating characteristics of the structure.

A feature which distinguishes compound semiconductor surfaces passivated by the above reference anodic process from semiconductor surfaces that have been treated with the aforementioned deposition techniques is the absence of oxides at the semiconductor/passivation interface. That is, with the anodic technique, oxides of the semiconductor material are removed from the surface as the passivation layer is grown into the semiconductor material.

Direct electroless growth, e.g., to form a sulfide passivation layer is also known to result in some surface oxide at standard film thicknesses, i.e, 30 - 50 Angstroms. Although surface oxides can be eliminated by increasing the film thickness, thicker films grown by electroless techniques do not adhere to the semiconductor surface as well as films less than 50 Angstroms thick.

It is now apparent that excellent passivation can be achieved by deposition of a single insulative layer provided that the layer is formed in direct contact with the semiconductor surface. Such interfacial contact has not been obtained with prior methods of depositing silicon dioxide and zinc sulfide. This is because the standard clean up techniques common to these deposition methods do not remove native oxides, e.g., oxides of the chalcogenide species, to expose a clean semiconductor surface. Rather, these techniques remove other residual surface contaminants formed as a result of various processing steps, e.g., polishing the surface. By way of example, a typical solvent clean up is performed with methanol. In some practices the clean up is a four step procedure consisting of a methanol wash followed by a tetrachloroethylene dewax step, another methanol wash and a final wash in isopropyl alcohol to remove the methanol.

According to the present invention it is now desirable to remove the native surface oxides which normally form during exposure to ambient oxygen before or after the standard polishing and clean up steps. A reduction in the density of oxidized chalcogenide allows for the formation of a greater number of relatively stable bonds between the semiconductor surface constituents and the overlying passivation layer. That is, substantial or complete removal of the relatively weak oxide bonds from the surface exposes a much greater density of dangling bonds.

By depositing the passivation layer in direct contact with this clean semiconductor surface it is possible to tie up a greater number of dangling bonds with the passivating material. With appropriate selection of the passivating material the interface is characterized by relatively strong, i.e., stable, bonds in comparison to the weaker oxide bonds which have in the past been retained at the interface of the semiconductor surface and the deposited layer.

By substantial removal of oxide bonds it is meant that a structure passivated according to the present invention is characterized by the absence of the typical native oxide layer which would otherwise be present at the interface between the semiconductor and the deposited passivation material. Typical oxide layers, even of minimal thickness, are clearly discernable layers, i.e., through electron spectroscopy or microscopy techniques.

By way of example, when a $Hg_{1-x}Cd_xTe$ substrate is polished with bromine the resulting surface region becomes Hg and Cd deficient and ambient oxygen readily reacts with the Te to predominantly form $TeO_2$. As a result 50 percent or more of the chalcogenide species (Te in this example), within the first 30 Angstroms below the semiconductor surface, is present in an oxidized state. It is believed that the native oxides can be completely removed by the process disclosed herein. Experimental data suggests that the residual oxidized chalcogenide concentration after oxide removal by the present preferred method ranges from zero to 2 percent of the chalcogenide concentration. Other embodiments of the method have been shown to reduce the oxidized chalcogenide concentration to approximately 10 percent of the chalcogenide concentration. More generally, within the first 30 Angstroms below the semiconductor surface, reduction of chalcogenide which is in an oxidized state to levels less than 17 percent of the total chalcogenide present is believed to result in sufficient passivation to provide satisfactory device performance.

In a preferred form of the invention the resulting passivated structure is characterized by the complete absence of oxidized chalcogenide at the interface region between the semiconductor surface and the passivating layer. More generally, the density of the oxidized chalcogenide about the interface is markedly reduced from that range of densities characteristic of other structures having deposited passivation layers. A feature common to structures passivated according to the method disclosed herein is the absence of a discernable oxide layer about the interface, e.g., identifiable by electron microscopy. That is, the amount of remaining oxide corresponds at most to one atomic layer of oxygen.

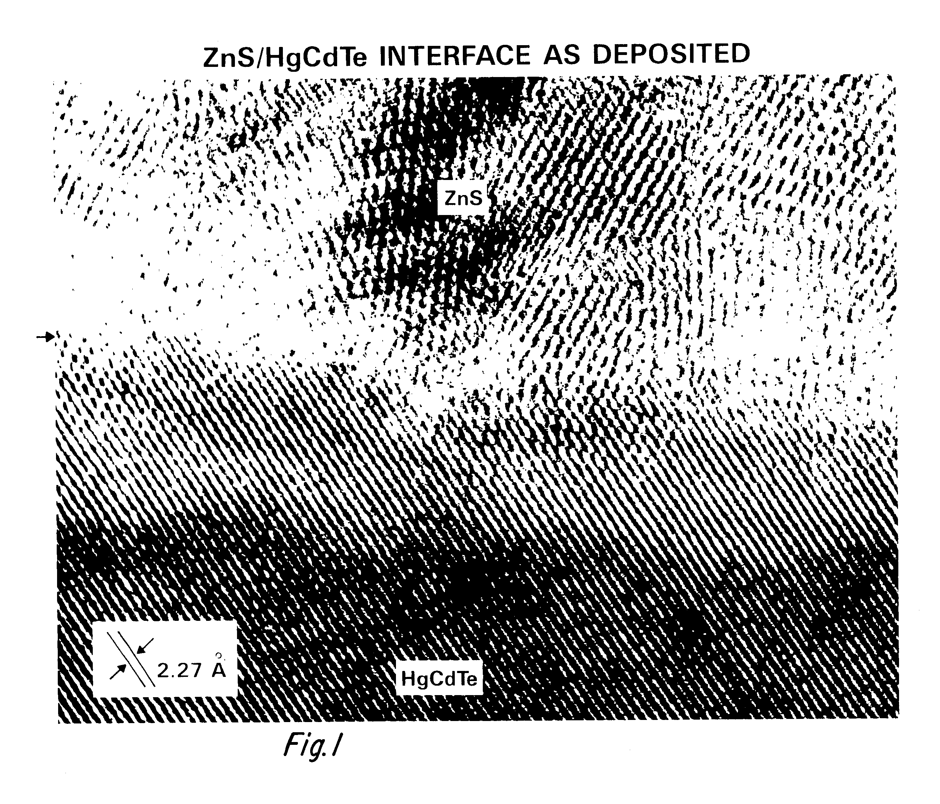

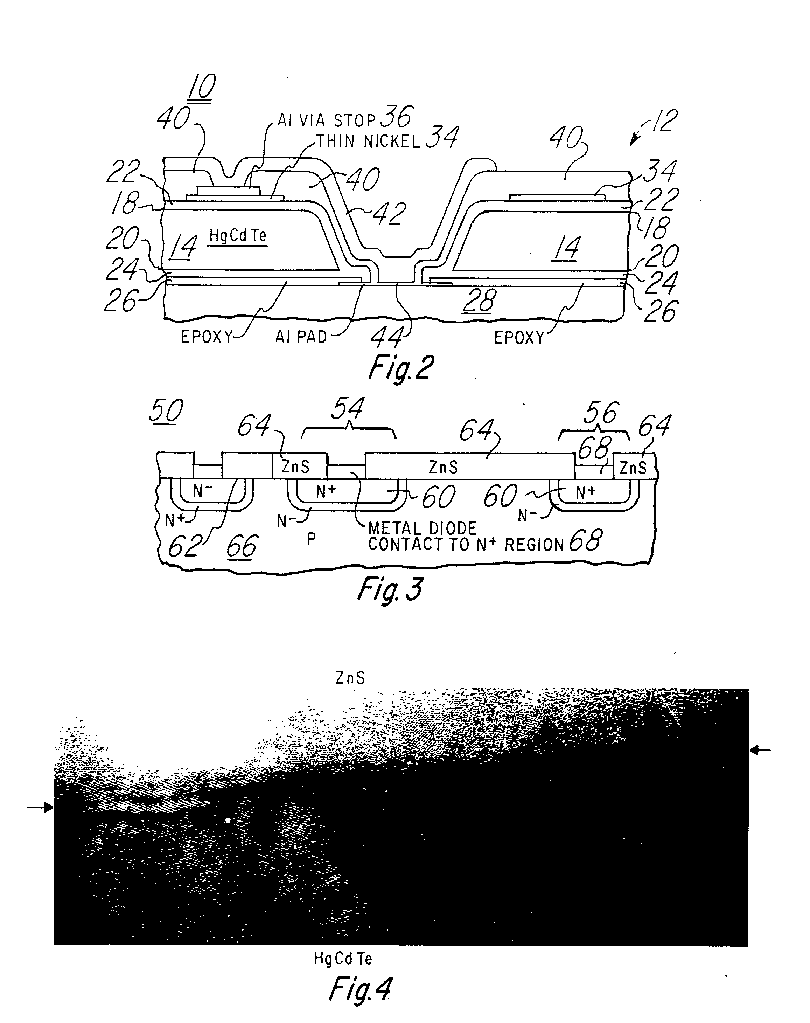

With reference to Figure 1, a lattice image of a preferred embodiment structure, e.g., a microcrystalline zinc sulfide layer deposited over an etched $Hg_{1-x}Cd_xTe$ surface, illustrates that with the removal of native oxide there is a direct and relatively abrupt transition between the crystalline semiconductor material and the overlying passivation material. (The transistion region is indicated generally daggers along the border of the Figure 3 micrograph.) This suggests a continuous interface wherein atoms in the different layers are bonded with one another. In this regard the cross sectional view of the interface may resemble that of a structure wherein the passivation layer has been grown into the semiconductor layer by anodic sulfidization.

Compositional and stoichiometric features distinguish structures passivated according to the present method from structures wherein the passivation layer has been grown into the semiconductor layer. In part, this is because the composition of a grown passivation layer will always be a function of the semiconductor composition. For example, just as the thermal growth of oxides and nitrides into a silicon lattice structure results in compounds of silicon, the anodic or electroless growth of chalcogenides in compound semiconductor materials such as $Hg_{1-x}Cd_xTe$ results only in chalcogenide containing compounds of the semiconductor constituents. In a photochemical process for growing a native sulfide layer such as disclosed in U.S. Patent No. 4,447,469, the ratio of sulfides is directly related to the value of X.

Furthermore, the degree to which the stoichiometry of grown passivation layers can be altered from that of the compound semiconductor material is quite limited. For anodic and electroless passivation processes the stoichiometry can be varied as a function of the solubility of the reactants and the reaction products vis-a-vis the reaction bath.

For the case of sulfides anodically grown into $Hg_{1-x}Cd_xTe$ (X = 0.22) with an electrolytic bath predominantly comprising ethylene glycol, e.g., 80% ethylene glycol and 20% water, Rutherford backscattering spectroscopy (RBS) confirms that the resulting films characteristically contain approximately 70% CdS, 30% HgS and less than one percent $TeS_2$. Strong, et. al., J. Vacuum Science and Technology A, Vol. 5, No. 5, pp. 3205 - 3210 (1987).

While it may appear more desirable to grown an anodic passivation layer of essentially pure CdS, e.g., by increasing the water content of the bath, this is not possible due to the relative solubilities of HgS, CdS and $TeS_2$ in water. Rather, by varying the composition of the bath, the resulting HgS content cannot be diminished to less than approximately ten percent. Furthermore, when substantial amounts of the reaction products are dissolved into the bath, a relatively porous layer having poor passivation properties is developed along the semiconductor interface. As a further example, electroless passivation in a 100 percent water bath forms a layer of sulfides of $Hg_{1-x}Cd_xTe$ (X = 0.22) comprising 74 percent CdS and 26 percent HgTe.

In contrast to processes which provide grown passivation layers the method disclosed herein provides a wide variety of passivated structures each having compositional and stoichiometric features that are independent of the semiconductor composition.

In practicing the present invention a surface of a compound semiconductor sample is treated to remove and/or prevent formation of surface contaminants including oxides of the semiconductor material. Next a layer of passivating material is formed in direct contact with the semiconductor surface, the direct contact allowing the passivating material to tie up dangling semiconductor bonds. Alternately, after the semiconductor surface is treated to remove or prevent formation of oxides of the semiconductor material, a single insulating layer is formed in direct contact with the semiconductor surface. In this embodiment a passivated structure is provided without having to form a passivating layer in addition to an insulating layer. In either case the resulting interface at the semiconductor surface is characterized by the absence of an identifiable layer comprising native oxide, e.g., more than a monolayer comprising one or more oxides of the compound semiconductor material.

A more detailed process flow according to a preferred embodiment of the invention is now presented for a device formed on the surface of a $Hg_{1-x}Cd_xTe$ sample.

Immediately following a standard polishing step and solvent clean-up (e.g., 1/8 percent bromine in methanol followed by a rinse with methanol and isopropanol), the semiconductor surface is etched to remove oxides of $Hg_{1-x}Cd_xTe$. This may be a wet etch or a dry, e.g., plasma, etch. It has been found that a treatment in dilute nitric acid for approximately 10 seconds satisfactorily removes the native oxide layer. More specifically, the wafer may be dipped in a room temperature solution containing 5 volume percent concentrated nitric acid and 95 volume percent deionized water, i.e., a 3.4 percent net nitric acid concentration. In addition it has been found that both dilute lactic acid and $HCl/H_2O_2$ will remove most of the oxide layer. It is noted that after the polishing step and prior to the etch treatment, e.g., with nitric acid, the surface may be ashed to more uniformly oxidize the surface prior to oxide removal.

Next the wafer is sequentially rinsed in deionized water and is then dried with nitrogen. Shortly after the drying step the wafer is placed in a deposition chamber which is evacuated to $10^{-6}$ Torr in order to minimize oxidation. The wafer is then heated to 50° C and the surface is exposed at 150 mTorr to $H_2S$ at a 30 sccm flow rate for 2 - 5 minutes. Dimethyl zinc is then introduced (2.2 scmm, 150 mTorr total pressure) to form a ZnS insulating passivation layer by metal-organic chemical vapor deposition (MOCVD), e.g., react 8 - 10 minutes for approximately 2000 Angstroms growth. The chamber is then purged with $H_2S$.

The $H_2S$ exposure prior to deposition of ZnS is believed to contribute to the further reduction of native oxide concentration about the resulting interface. Apparently dissociated $H_2S$ reduces the native oxides to form OH or $H_2O$. This second reduction reaction in combination with the aforementioned wet or dry etch diminishes the oxidized chalcogenide concentration about the interface to less than 2 percent of the chalcogenide concentration. Other reduction reactions, e.g., such as exposing disociated $H_2Se$, $H_2Te$ or atomic hydrogen to the semiconductor surface, in lieu of $H_2S$, may be employed to diminish the concentration of native surface oxides. However, exposure to $H_2S$ alone is insufficient to reduce the concentration of native surface oxide to an acceptable level. This is confirmed by measurement of increased hysteresis on devices which have not been adequately etched in nitric acid prior to ZnS deposition by MOCVD.

Experiments confirm that according to an alternate embodiment process flow the insulating passivation layer may be formed over the semiconductor surface by evaporative deposition instead of MOCVD while maintaining acceptable device performance. The ability to form a high quality passivation layer by evaporative deposition is a feature of the present invention whereas prior efforts to passivate by evaporative deposition have been marked by relatively poor electrical properties (as well as inadequate adhesion between the insulative layer, e.g., ZnS, and the surface region of the semiconductor material). Improvements in electrical performance are also attributed to removal, prior to depositing the passivation layer, of native surface oxides which form during exposure to ambient oxygen before or after the standard polishing and clean up steps. Improvements in the adhesion properties of passivation layers formed by evaporative deposition may also be achievable when native oxides are removed, e.g., by treating the semiconductor surface in dilute nitric acid prior to deposition.

In limited testing wherein the evaporative deposition process was performed without employing a second reduction reaction, e.g. exposure to dissociated $H_2S$, a higher concentration of oxidized chalcogenide was measured in the passivated structure than was observed in structures formed according to the above described preferred embodiment. From these measurements it appears that acceptable device performance, e.g., less than 100 mV hysteresis, can be obtained when the oxidized chalcogenide concentration ranges up to approximately 10 percent of the total chalcogenide concentration in regions located within 30 Angstroms of the interface, or approximately one monolayer of chalcogenide.

By way of example, acceptable device performance for typical MIS capacitor detection elements corresponds to a hysteresis of less than 100 mV as measured between the storage gate and the semiconductor material. For a typical device having a 1700 Angstrom thick ZnS passivation layer, the hysteresis is measured in the depletion regime during a bias voltage sweep extending 3 Volts on each side of the flatband voltage. Acceptable device performance also corresponds to a flatband uniformity, e.g. across an array of detector elements, to within 100 mV, i.e. a standard deviation of 25 mV, among the array elements.

The process is applicable to formation of both photodiode and photocapacitor imaging devices including one dimensional and focal plane array devices. Figure 2 schematically presents a detector array 10 in a cut-away partial cross sectional view to illustrate a photocapacitive detector element 12. In this exemplary embodiment a single crystal n type $Hg_{1-x}Cd_xTe$ slice, approximately 12 microns thick, has been patterned and etched with bromine-methanol to form an array of semiconductor members 14, each member being a component of a different photodetector element 12.

The semiconductor members 14 include upper and lower surfaces 18 and 20 which have each been passivated according to the preferred embodiment process flow. Accordingly, a first passivation layer 22 is formed along the upper surface 18 and a second passivation layer 24 is formed along the lower surface 20. The lower passivation layer, which is on the order of 2,000 Angstroms thick, is bonded with an epoxy layer 26 to a silicon processor chip 28. Preferably the first passivation layer 22 also serves as an insulator and is deposited to a thickness ranging between 1800 and 2,000 Angstroms. By way of example, a ZnS layer deposited according to the preferred method will provide satisfactory insulative properties. Although not illustrated, the passivation layer could be relatively thin, e.g., less than 200 Angstroms, with a relatively thick insulative layer deposited directly over the passivation layer 22.

Metal deposition with well known lift-off techniques provides a thin storage gate 34 of semi-transparent metal (e.g. 50 Angstroms of nickel or chromium) and an aluminum via stop 36. One or more additional insulative layers, e.g., 40, are deposited over the via stop 36. The gate 34 makes electrical contact to the silicon processor chip 28 through a metal interconnect level 42 and an aluminum contact pad 44.

Figure 3 schematically illustrates in a partial cross sectional view a one or two dimensional photodiode detector array 50 comprising first and second array elements 54 and 56 each including a pn region 60 formed along the surface 62 of a II - VI compound semiconductor material 66, e.g., $Hg_{1-x}Cd_xTe$. Each element also includes an ohmic contact 68 formed along the surface 62 by, for example, by standard lift-off techniques. A passivation layer 64, e.g., ZnS, is also formed along the surface 62 and about the contacts 68 to cover the semiconductor surface 62 about each element 54 and 56. The passivation layer 64 is deposited according to the above described process flow, preferably with a brominemethanol etch. In the structure of Figure 3, as well as other embodiments of the invention, the passivation layer may only perform the function of passivation. If deposited to a suitable thickness the layer 64 may also provide physical passivation, e.g., protection from physical damage.

With regard to hybrid circuit structures such as illustrated in Figures 2 and 3, it is noted that when compound semiconductor wafers are thinned for mounting on a processor the underside which is bonded to the processor may be passivated prior to performing the patterning and etch steps which result in individual pixels. By way of example the bonded surface 20 is lapped, polished and then passivated according to the method disclosed herein to provide a ZnS layer over the underside of the wafer. Because the ZnS is chemically bonded to the semiconductor material, i.e., there is no intermediate oxide layer, this deposited passivation layer provides sufficient structural integrity for bonding the slice to the processor chip 28. In the past the passivation layer would have been grown into the semiconductor material in order to provide sufficient integrity.

Additional details relating to this device structure and formation thereof are more fully discussed in U.S. Patent No. 4,686,373 which is assigned to the assignee of the present invention and now incorporated by reference. Other types of infrared detectors and arrays of detectors incorporate passivation - insulative layers of various kinds. These detectors and arrays may similarly be fabricated by passivation according to the present invention. Because excellent passivation is now achievable with a high quality dielectric material such as, for example, CdTe, many such detectors may comprise a single passivating insulative layer along the semiconductor surface in lieu of a passivating layer and a separate insulating layer.

## MODIFICATIONS AND ADVANTAGES

Various modifications of the preferred embodiment passivated structure and method may be made while retaining the feature of forming a layer of passivating material in direct contact with the semiconductor surface. In the case of $Hg_{1-x}Cd_xTe$ the layer overlying the semiconductor surface may preferably be an insulator such as ZnS, CdTe, CdS, CdSe, ZnSe or ZnTe. Generally, II - VI compounds which do not contain substantial amounts of mercury are believed to be suitable. The passivation layer may also comprise other insulators such as $SiO_2$, $Si_3N_4$ and combinations thereof. Of course, the process may be used to passivate other compound semiconductor materials including, but not limited to II - VI materials such as $Hg_{1-x}Mn_xTe$ and $Hg_{1-x-y}Zn_yTe$. The resulting structures include as distinguishing features: bonds formed between the passivation layer and the semiconductor layer and the absence of a distinct layer of native oxide at the interface.

It is intended that the method be applied to passivate thin films of semiconductor material such as LPE or VPE films on various substrates such as CdTe, CdZnTe and CdMnTe as well as other compound semiconductors.

## ADDITIONAL FEATURES OF THE INVENTION

As noted above, devices passivated according to the present method are characterized by the absence of a native oxide layer, i.e., a layer comprising one or more oxides of the semiconductor material, at or near the interface between the insulative layer and the semiconductor material. In addition, numerous features further distinguish the resulting structures from prior art devices which are also characterized by the absence of a native oxide layer, e.g., devices which are passivated by molecular beam epitaxial growth of a CdTe layer over an in situ MBE grown semiconductor layer; and devices formed by anodic and electroless chemical growth techniques.

Figure 4 provides a lattice image obtained by high resolution transmission electron microscopy for a $Hg_{1-x}Cd_xTe$ (X = 0.22) surface passivated according to the present method. The image illustrates a portion of the interface region between a ZnS passivation layer and the semiconductor surface. Due to the standard polishing step a nonuniformity exists along the plane of the semiconductor surface. A corresponding interfacial roughness in the form of a ripple 50 results at the interface between the deposited ZnS layer and the semiconductor surface. This roughness, i.e., ripple amplitude, typically varies from 10 to 15 Angstroms peak to peak about the interface.

Although comparable interfacial roughness is known to be characteristic of anodic and electroless chemical growth techniques (also due to polishing steps), the interface between the semiconductor and passivation layers of a structure which is both grown and passivated by MBE is substantially planar. That is, when a II - VI compound semiconductor surface and an overlying CdTe passivation layer are sequentially formed in an in situ MBE process, the polishing step is omitted and the interfacial roughness is limited to the interplanar spacing, e.g., approximately 3 Angstroms.

Another feature which distinguishes devices passivated according to the present method from devices passivated by anodic growth and electroless chemical growth techniques is the near or complete absence of a diffusion region about the interface. In those processes wherein the passivation layer is chemically grown into the semiconductor surface to form a passivation layer there results a relatively thick, e.g., 50 Angstroms, compositionally graded diffusion region within the passivation layer along the interface with the semiconductor; and the above noted interfacial roughness is observable as a ripple at the forward portion of the diffusion front. In contrast, essentially no diffusion layer and no compositional gradient are observable in devices passivated according to the present method. If any diffusion region exists near the interface it is limited to a only few atomic layers, i.e., less than 10 Angstroms.

Semiconductor devices passivated according to the present method are characterized by surface state densities comparable to or better than those attainable with anodically grown passivation layers. Surface state densities less than $2 \times 10^{11}$ $cm^{-2}eV^{-1}$ and fixed charge densities ranging from $-7 \times 10^{10}$ $cm^{-2}$ to $-16 \times 10^{10}$ $cm^{-2}$ are attainable with the invention. A surface state density of $1.5 \times 10^{11}$ $cm^{-2}eV^{-1}$ has been measured.

Certain preferred embodiments of the invention have been described. Other arrangements and modifications will be apparent when applying the present teachings to various device structures. Accordingly, the scope of the invention is to be limited only by the claims which follow.

## Claims

1. A semiconductor device comprising:
a layer having an upper surface formed of II - VI compound semiconductor material; and
an insulative layer formed in direct contact with the upper surface of the semiconductor layer said device characterized by the absence of an intermediate native oxide layer within 30 Angstroms of the resulting interface, an interfacial roughness of at least 5 Angstroms and a diffusion region of thickness Z wherein Z ranges from zero to 10 Angstroms.

2. The device of Claim 1 wherein less than 5 percent of any chalcogenide within 30 Angstroms of the interface is in an oxidized state.

3. The device of Claim 1 wherein within the layer of II-VI semiconductor material less than 5 percent of any chalcogenide within 30 Angstroms of the interface is oxidized.

4. The device of Claim 1 wherein less than 2 percent of any chalcogenide within 30 Angstroms of the interface is in an oxidized state.

5. The device of Claim 1 wherein within the layer of II-VI semiconductor material less than 2 percent of any chalcogenide within 30 Angstroms of the interface is in an oxidized state.

6. The device of Claim 1 wherein Z < 6 Angstroms.

7. The device of Claim 1 wherein Z = 0.

8. The device of Claim 1 wherein the compound semiconductor material is $Hg_{1-x}Cd_xTe$.

9. The device of Claim 8 wherein X ranges from 0.2 to 0.3.

10. The device of Claim 8 wherein X = 0.22.

11. The device of Claim 1 wherein the insulative layer comprises one or more II - VI compounds.

12. The device of Claim 1 wherein the insulative layer comprises one or more materials taken from the group consisting of ZnS, CdTe, CdS, CdSe, ZnSe, and ZnTe.

13. The device of Claim 1 wherein the insulative layer is characterized by deposition over the upper surface after removal of native oxide from the substrate.

14. The device of Claim 1 wherein the composition and stoichiometry of the insulative layer are independent of the substrate composition.

15. The device of Claim 1 wherein the insulative layer comprises one or more elements not present in the II - VI compound semiconductor material.

16. The device of Claim 1 wherein the interfacial roughness ranges from 10 to 20 Angstroms.

17. The device of Claim 1 wherein the interfacial roughness ranges from 10 to 15 Angstroms.

18. The device of Claim 1 wherein the surface state density is less than $5 \times 10^{11}$ $cm^{-2}eV^{-1}$.

19. The device of Claim 1 wherein the surface state density is less than $2 \times 10^{11}$ $cm^{-2}eV^{-1}$.

20. The device of Claim 1 wherein the surface state density is $1.5 \times 10^{11}$ $cm^{-2}eV^{-1}$.

21. The device of Claim 1 wherein the fixed charge density ranges from $-7 \times 10^{10}$ $cm^{-2}$ to $-16 \times 10^{10}$ $cm^{-2}$.

22. The device of Claim 1 wherein $Z < 6$ Angstroms and less than 5 percent of any chalcogenide within 30 Angstroms of the interface is in an oxidized state.

23. The device of Claim 1 further characterized by the absence of any oxide layer between the semiconductor material and the insulative layer.

24. A semiconductor device comprising:
a layer having an upper surface formed of II - VI compound semiconductor material; and
a passivation layer formed in direct contact with the upper surface of the semiconductor layer, the resulting interface characterized by an interfacial roughness of at least 5 Angstroms, a compositionally graded diffusion region of thickness Z wherein Z ranges from zero to 10 Angstroms, said device further characterized in that within the layer of II - VI semiconductor material less than 20 percent of any chalcogenide within 30 Angstroms of the interface is in an oxidized state.

25. The device of Claim 24 wherein less than 15 percent of any chalcogenide within 30 Angstroms of the interface is in an oxidized state.

26. The device of Claim 24 wherein within the layer of II - VI semiconductor material less than 10 percent of any chalcogenide within 30 Angstroms of the interface is in an oxidized state.

27. The device of Claim 24 wherein less than 10 percent of any chalcogenide within 30 Angstroms of the interface is in an oxidized state.

28. The device of Claim 24 wherein with the layer of II - VI semiconductor material less than 2 percent of any chalcogenide within 30 Angstroms of the interface is in an oxidized state.

29. The device of Claim 24 wherein less than 2 percent of any chalcogenide within 30 Angstroms of the interface is in an oxidized state.

30. The device of Claim 24 wherein no chalcogenide within 30 Angstroms of the interface is in an oxidized state.

31. The device of Claim 24 wherein the interfacial roughness ranges from 15 to 20 Angstroms.

32. The device of Claim 24 wherein $Z < 6$ Angstroms.

33. The device of Claim 24 wherein $Z = 0$.

34. The device of Claim 24 wherein the passivation layer comprises one or more II - VI compounds.

35. The device of Claim 24 wherein the passivation layer comprises one or more materials taken from the group consisting of ZnS, CdTe, CdS, CdSe, ZnSe and ZnTe.

36. The device of Claim 24 wherein the passivation layer is characterized by deposition over the upper surface after removal of native oxide from the substrate.

37. The device of Claim 24 wherein the composition and stoichiometry of the insulative layer are independent of the substrate composition.

38. The device of Claim 24 wherein the compound semiconductor material is $Hg_{1-x}Cd_xTe$.

39. The device of Claim 24 wherein $Z < 6$ Angstroms and less than 5 percent of any chalcogenide within 30 Angstroms of the interface is in an oxidized state.

40. A process for fabricating a compound semiconductor device comprising the step of:
depositing a passivation layer in direct contact with the surface of a sample of compound semiconductor material, the resulting structure characterized by the absence of an intermediate layer of native oxide.

41. The process of Claim 40 further comprising the step of treating the surface of the compound semiconductor sample to remove surface contaminants such as oxides of the semiconductor material before depositing the passivation layer.

42. The process of Claim 41 further comprising the step of polishing the semiconductor surface before removing oxide surface contaminants.

43. The process of Claim 42 wherein the polishing step is performed with a bromine methanol solution.

44. The process of Claim 41 wherein the step of treating the semiconductor surface is performed with an acid which removes native oxides.

45. The process of Claim 42 further comprising the step of ashing the surface after the polishing step.

46. A process for fabricating a compound semiconductor device comprising the steps:
treating the surface of a compound semiconductor sample to remove surface contaminants such as oxides of the semiconductor material; and

forming a passivation layer in direct contact with the semiconductor surface, the resulting structure characterized by the absence of an intermediate layer of native oxide.

47. The process of Claim 46 further comprising the step of forming an insulative layer over the passivation layer.

48. The process of Claim 46 further comprising the step of polishing the semiconductor surface before removing oxide surface contaminants.

49. An imaging device comprising:

a semiconductor member having a first surface formed of a II - VI compound semiconductor material;

a passivation layer formed in direct contact with the first surface, the resulting interface characterized by an interfacial roughness of at least 5 Angstroms, a compositionally graded diffusion region of thickness Z wherein Z ranges from zero to 10 Angstroms, all portions of the member within 30 Angstroms of the interface comprising less than 15 percent oxidized chalcogenide.

50. The device of Claim 49 wherein the first surface is formed of $Hg_{1-x}Cd_xTe$.

51. The device of Claim 49 wherein the surface state density is less than $2 \times 10^{11} \ cm^{-2} \ eV^{-1}$.

52. The device of Claim 49 further comprising:

a storage gate formed over the passivation layer;

a via stop formed over the storage gate; and

an insulative layer formed over the via stop thereby forming a photocapacitive detector element.

53. The device of Claim 49 further including a processor bonded to the passivation layer to form a hybrid circuit structure.

54. The device of Claim 49 further including an epoxy layer bonding the processor to the passivation layer.

55. The device of Claim 49 wherein the passivation layer predominately comprises ZnS.

56. The device of Claim 49 wherein the passivation layer serves as an insulative level.

57. The imaging device of Claim 49 wherein the semiconductor member includes a plurality of array elements each element including a 34 pn region formed along the first surface.

58. The imaging device of Claim 57 wherein each element includes an ohmic contact formed over the pn region and surrounded by the passivation layer.

# ZnS/HgCdTe INTERFACE AS DEPOSITED

ZnS

2.27 Å

HgCdTe

*Fig. I*

EP 0 366 886 A1

Neu eingerei
Nouvellen

Fig.2

Fig. 3

ZnS

HgCdTe

Fig.4

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| X | APPLIED PHYSICS LETTERS, vol. 51, no. 19, 9th November 1987, pages 1521-1523, American Institute of Physics, New York, NY, US; G. SUDO et al.: "Reduction of Hg1-x Cdx Te native oxide during the SiNx deposition process" * Whole document * | 40 | H 01 L  21/471 H 01 L  31/18 H 01 L  31/113 H 01 L  27/146 |
| A | IDEM | 1-39,41 -48 | |
| X | JOURNAL OF THE ELECTROCHEMICAL SOCIETY, vol. 135, no. 5, May 1988, pages 1252-1255, Manchester, NH, US; N. KAJIHARA et al.: "Silicon nitride passivant for HgCdTe n+p diodes" * Page 1253, left-hand column, chapter "Experiment"; page 1254, left-hand column, paragraph 2 * | 40,41 | |
| A | IDEM | 1-39,42 -48 | TECHNICAL FIELDS SEARCHED (Int. Cl.5) |
| X | J. VAC. SCI. TECHNOL. A, vol. 6, no. 4, July/August 1988, pages 2765-2771, American Vacuum Society; E. WEISS et al.: "The characterization of anodic fluoride films on Hg1-xCdxTe and their interfaces" * Abstract; page 2765, right-hand column, last paragraph - page 2766, left-hand column, paragraph 1 * | 40-43, 46-48 | H 01 L |
| A | US-A-4 726 885  (TEXAS) * Figure 1B; claims * | 1-58 | |

-/-

The present search report has been drawn up for all claims

| Place of search | Date of completion of the search | Examiner |
|---|---|---|
| THE HAGUE | 30-01-1990 | GORI P. |

Page     2

European Patent
Office

**EUROPEAN SEARCH REPORT**

Application Number

EP  89 11 4894

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| A | J. APPL. PHYS., vol. 58, no. 1, 1st July 1985, pages 366-373, American Institute of Physics; Y. NEMIROVSKY et al.: "Interface of p-type Hg1-xCdxTe passivated with native sulfides" * Abstract; page 370, chapter C: "Surface analytical characterization" - to the end * ----- | 1-58 | |
| | | | TECHNICAL FIELDS SEARCHED (Int. Cl.5) |

The present search report has been drawn up for all claims

| Place of search | Date of completion of the search | Examiner |
|---|---|---|
| THE HAGUE | 30-01-1990 | GORI P. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P0401)